**Europäisches Patentamt**

**European Patent Office**

**Office européen des brevets**

(11) Veröffentlichungsnummer: **0 355 542**
**A1**

# EUROPÄISCHE PATENTANMELDUNG

(21) Anmeldenummer: **89114519.5**

(22) Anmeldetag: **05.08.89**

(51) Int. Cl.⁴: **C08G 75/02 , H01B 3/30**

(30) Priorität: **18.08.88 DE 3828056**

(43) Veröffentlichungstag der Anmeldung:
**28.02.90 Patentblatt 90/09**

(84) Benannte Vertragsstaaten:
**BE DE ES FR GB IT NL**

(71) Anmelder: **BAYER AG**

**D-5090 Leverkusen 1 Bayerwerk(DE)**

(72) Erfinder: **Köhler, Karl-Heinz, Dr.**
**Buschstrasse 165**
**D-4150 Krefeld(DE)**
Erfinder: **Reinking, Klaus, Dr.**
**Robert-Stolz-Strasse 16b**
**D-5632 Wermelskirchen(DE)**
Erfinder: **Kraft, Klaus, Dr.**
**Doerperhofstrasse 15**
**D-4150 Krefeld(DE)**

(54) **Polyarylensulfid-Formmassen und deren Verwendung als Einbettmasse für aktive und passive elektronische Bauelemente.**

(57) ·Die Erfindung betrifft Formmassen aus Polyarylensulfiden (PAS), vorzugsweise Polyphenylensulfiden (PPS) mit verzögerter Kristallisation und niedrigem Ionengehalt und deren Verwendung als Einbettmasse für aktive und passive elektronische Bauteile.

EP 0 355 542 A1

**Polyarylensulfid-Formmassen und deren Verwendung als Einbettmasse für aktive und passive elektronische Bauelemente**

Die Erfindung betrifft Formmassen aus Polyarylensulfiden (PAS), vorzugsweise Polyphenylensulfiden (PPS) mit verzögerter Kristallisation und niedrigem Ionengehalt und deren Verwendung als Einbettmasse für aktive und passive elektronische Bauteile.

Polyarylensulfid-Formmassen und deren Einsatz im Elektronik-Sektor sind bekannt (z.B. EP-OS 119 607, EP-OS 100 913).

Bestimmte elektronische Bauteile jedoch stellen hohe Anforderungen an die Materialien mit denen sie zur Sicherung ihrer Funktion umspritzt werden. So werden z.B. für die Umhüllung von Mikrochips Einbettmassen benötigt, die einen sehr geringen Rest-Ionen-Gehalt besitzen, die eine sehr hohe Resistenz gegenüber thermischen, chemischen und hydrolytischen Einflüssen auf weisen und die bei der thermoplastischen Verarbeitung das zu umhüllende elektronische Bauteil nicht mechanisch deformieren.

Es ist bekannt, daß beim Eindiffundieren von Feuchtigkeit in das Bauteil durch das Anlösen von ionogenen Bestandteilen in der Einbettmasse Elektrolyte entstehen können, die unerwünschte störende elektrische Ströme ermöglichen können, so daß die elektronische Funktion der Bauteile beeinträchtigt werden kann.

Die Forderung nach Resistenz gegenüber thermischen, chemischen und hydrolytischen Einflüssen resultiert aus der Herstellung und der nachfolgenden Bearbeitungs- und Montage-Prozeßen der elektronischen Bauteile. So entstehen z.B. bei Lötvorgängen hohe Temperaturen, bei denen auch die Flammfestigkeit des Materials von Bedeutung ist. Nachbehandlungen wie z.B. chemische Ätzungen, Reinigungen u.ä. bzw. Einfluß von Luftfeuchtigkeit erfordern die chemische und hydrolytische Beständigkeit des zu verwendenden Thermoplasten.

Polyarylensulfide, insbesondere Polyphenylensulfide erfüllen diese Forderungen in besonderer Weise. Es hat sich jedoch gezeigt, daß bei der Umspritzung von mechanisch empfindlichen Bauteilen Deformationen auftreten können, wie z.B. das Verwehen oder Abreißen von Bonddrähten an Mikrochips, die die elektronische Funktion der Bauteile stören bzw. zunichte machen können. Solche Deformations-Prozeße, die beim Umspritzen des Bauteils auftreten, können auch bei einwandfreier Werkzeugkon struktion nicht vermieden werden, 'wenn die Viskosität der einströmenden ·Schmelze zu hoch ist. Die Viskosität der einströmenden Schmelze hängt im wesentlichen ab von der Art und Menge des Füllstoffs, von der Viskosität des eingesetzten Polyarylensulfids und dem Kristallisations-Verhalten des Polyarylesufids.

Art und Menge des Füllstoffs sind im allgemeinen durch das Anforderungs-Profil der Formmasse vorgegeben und nur in geringen Grenzen variabel.

Die Viskosität des eingesetzten Polyarylensulfids muß niedrig sein. Dies hat zur Folge, daß aufgrund der zunehmenden Kristallisationsgeschwindigkeit von Polyarylensulfiden und abnehmender Viskosität bzw. geringere Molekulargewicht beim Spritzguß-Vorgang eine vorzeitige Kristallsiation einsetzt, die ihrerseits wieder eine Viskositäts-Erhöhung der Schmelze bewirkt. D.h., der Minderung der Viskosität bzw. des Molekulargewichts des eingesetzten Polyarylensulfids sind Grenzen gesetzt, wenn es nicht gelingt, dessen Kristallisation entsprechend zu verzögern.

Es ist bekannt, die Kristallisation von Polyarylensulfiden sehr stark zu unterdrücken oder gänzlich aufzuheben, wenn die Polyarylensulfide aus bestimmten Struktur-Elementen bestehen oder solche in Form von Co-Polyarylensulfiden enthalten wie z.B. m-Phenylensufid-Ein heiten (z.B. DE-OS 2 953 485) oder Alkyl-Phenylensulfid-Einheiten (Houben-Weyl, Bd. E 20, Sp. 2548) oder weiteren Comonomer-Einheiten (z.B. DE-OS 3 637 813).

Solche amorphen oder unvollständig kristallisierenden Polyarylensufide verlieren im Vergleich zu teilkristallinen Polyarylensulfiden wesentliche Eigenschaften, wie z.B. die Temperatur-Beständigkeit, die Chemikalien-Resistenz und die Hydrolyse-Festigkeit. Daher besteht die Forderung nach teilkristallinen Materialien, die genügend hohe Schmelzpunkte aufweisen. Sie sollen z.B. gegenüber Lötbädern, die auf Temperaturen von ca. 260 °C aufgeheizt sind, formbeständig sein.

Aufgabe der Erfindung war es also, leichtfließende Formmassen bereitzustellen, die teikristalline Polyarylensulfide mit einem Schmelzpunkt von mehr als 260 °C enthalten die während des Umspritz-Vorganges nicht vorzeitig, d.h. nicht vor Beendigung des Formfüllens kristallisieren und die außerdem einen geringen Ionen-Gehalt aufweisen.

Es wurde nun gefunden, daß bestimmte (Co)polyarylensulfide, vorzugsweise (Co)Polyphenylensulfide geringer Schmelzviskosität, die einen besonders niedrigen Ionen-Gehalt aufweisen, den gewünschten Anforderungen entsprechen.

Die erfindungsgemäßen thermoplastischen Formmassen bestehen aus

2

(A) 20-100 Gew.% Polyarylensulfiden, vorzugsweise Polyphenylsulfiden, mit einer Schmelzviskosität von 5 bis 20 Pa's und einem Schmelzpunkt >260°C und einem Kristallisations-Verhalten der math. Beziehung (I)

$$tg_K\ (170)\ \rangle\ t_K\ (T_o)\ \cdot\ \frac{U(170)}{U\ (T_.)}\qquad (I),$$

und einem Gesamtionengehalt von weniger als 200 ppm und

(B) 0 bis 80 Gew.% Füllstoffen.

Bevorzugte Formmassen bestehen aus 30 bis 90 Gew.% der genannten Polyarylensulfide, vorzugsweise Polyphenylensulfid, und 70 bis 10 Gew.% Füllstoffen.

In Gleichung (I) bedeuten

$$U(T) = 10^{[C_1/T-90t\ +C_2/(T+273)}\ \cdot\ (301-T)]};$$

wobei

$t_K$ (170) die isotherme Kristallisationszeit bei 170°C und $t_K$ (T.) die isotherme Kristallisationszeit bei einer beliebigen Temperatur T. ist, bei der sich $t_k$ gut bestimmen kläßt; U eine Funktion der Temperatur ist, in der $C_1$ = 55,9 und $C_2$ = 93 538 ist.

Die Polyarylensulfide der erfindungsgemäßen Formmassen haben eine Schmelzviskosität von 5 bis 20 Pa.s (gemessen bei 306°C, bei einem Schergefälle je von $10^3$ (1/s)), vorzugsweise kleiner 15 Pa.s, besonders bevorzugt kleiner 10 Pa.s. Sie haben einen Schmelzpunkt $T_S$ von größer 260°C, vorzugsweise größer 270°C.

Die Polyarylensulfide der erfindungsgemäßen Formmassen besitzen einen Gesamt-Ionen-Gehalt, bezogen auf Polyarylensulfid, von weniger als 200 ppm, insbesondere weniger als 100 ppm und besonders bevorzugt weniger als 50 ppm.

Die Reduktion der Kristallisationsgeschwindigkeit kann durch Verwendung von 1 bis 5 mol-% Comonomer (bezogen auf Dihalogenaromat, z.B. p-Dichlorbenzol) erreicht werden. Die Herstellung der Polymeren kann z.B. analog der DE-OS 3 637 813, EP-OS 171 021, US-PS 3 354 129 u.s.w. aus entsprechenden Ausgangsmaterialien erfolgen.

Zur Einstellung des erfindungsgemäßen Gehaltes an (Wasser)löslichen Ionen werden die nach bekannten Verfahren hergestellten Polyarylensulfide bzw. Copolyphenylsulfide nach der Polymerisationsreaktion durch eine kontinuierliche Temperung mit einer definierten Abkühlrate nach bekannten technischen Verfahren auf geeignete Temperatur gebracht, in ein Verdünnungsmittel (z.B. $C_1$-$C_{10}$-Alkohole) eingebracht und anschließend mit einer Flüssigkeit (z.B. Wasser) gewaschen und anschließend gegebenenfalls getrocknet.

Die kontinuierliche Temperung kann nach bekannten Verfahren wie z.B. Rühren der Umsetzungslösung, Einbringen in Kühleinrichtungen, Durchblasen von gekühlten Gasen (z.B. Luft, $N_2$ usw.) erfolgen.

Das Polymere wird auf eine Temperatur von 15 bis 150°C abgekühlt.

Die Abkühlgeschwindigkeit kann in weiten Grenzen variiert werden, z.B. von 100°C/sec bis 100°C pro Stunde, vorzugsweise 80°C/min bis 200°C/min.

Das Polymere kann gegebenenfalls nach üblichen Methoden, z.B. im Vakuum (bis $10^{-3}$ bar) bei erhöhter Temperatur (z.B. bis 150°C) getrocknet werden.

Der Gesamt-Ionen-Gehalt umfaßt die Summe aus Kationen und Anionen. Beispiele für solche Kationen sind $H^+$, $Li^+$, $Na^+$, $K^+$, $Fe^{2+}$, $Ti^{2+}$ u.s.w.; Beispiele für Anionen sind $Cl^-$, $Br^-$, $SO_n^{2-}$ (z.B. $SO_3^{2-}$, $SO_4^{2-}$), Carboxylate usw.

Die Bestimmung der Kationen kann nach üblichen Methoden der Element-Analyse, z.B. Atom-Absorptions-Spektroskopie (z.B. nach vorangegangenem geeignetem Aufschluß) erfolgen. Die Bestimmung der Anionen kann z.B. nach Lösen des Polyarylensulfids in einem geeigneten Lösungsmittel durchgeführt werden u.s.w.

Polyarylensulfide und Copolyarylensulfide, die für die erfindungsgemäßen Formmassen geeignet sind, werden in Abwandlung bekannter Verfahren (z.B. DE-OS 3 529 500, 3 529 501, 3 529 498) durch geeignete Modifikation im Herstellungsverfahren (DE-OS 3 637 813) und bei der Aufarbeitung erhalten.

Die Einstellung des erfindungsgemäß geringen Ionen-Gehaltes im Polyarylensulfid geschieht z.B. durch Temper-Prozeße in geeigneten Lösungsmitteln, wodurch eine weitgehende Abtrennung ionogener Bestandteile aus den Polyarylensulfiden erreicht wird.

Die erfindungsgemäßen Formmassen enthalten Füllstoffe, die weitgehend frei sind von wasserlöslichen Ionen. Beispiele für solche Füllstoffe sind: Quarzmehl, Quarzgut, Kaolin, Glimmer, Talkum, $BaSO_4$, Glasku-

geln, gefällte pyrogene Kieselsäure usw.; bevorzugte Füllstoffe sind Quarzmehl, Quarzgut. Die Füllstoffe können auch faserige Verstärkungsstoffe sein, insbesondere anorganische Fasern wie z.B. Glasfasern.

Die Füllstoffe können geeignete Schichten und/oder Haftvermittler enthalten.

Die Menge an Füllstoff kann maximal 80 Gew.-% bezogen auf Formmasse betragen, vorzugsweise weniger als 70 %. Es können teilchenförmige und fasrige Füllstoffe nebeneinander vorliegen; der Anteil fasriger Stoffe beträgt vorzugsweise weniger als 50 Gew.-% bezogen auf Gesamtfüllstoff.

Die Formmassen besitzen eine Schmelzviskosität bei 340 °C und einem Schergefälle $\gamma$ (Gamma-Punkt) von $10^3$ (1/S: von weniger als 100 Pa.s, vorzugsweise weniger als 80 Pa.s und besonders bevorzugt von weniger als 50 Pa.s.

Die erfindungsgemäßen Formmassen können darüberhinaus übliche Verarbeitungshilfsmittel, z.B. Entformungshilfsmittel, Fließhilfsmittel zur weiteren Verbesserung der Fließfähigkeit, übliche Stabiilsatoren, z.B. zur Erhöhung der thermischen und UV-Stabilität, usw. enthalten.

Die Herstellung der Formmassen geschieht durch Schmelzcoumpoundierung auf üblichen Aggregaten wie Knetern oder Zwei-Wellen-Extrudern.

Die erfindungsgemäßen Formmassen finden z.B. Verwendung zum Umspritzen von passiv-Bauelementen, wie Kondensatoren, Widerständen, von aktiven Bauelementen, Transistoren, Dioden und integrierten Schaltungen (z.B. Mikrochips) usw., die u.a. nach dem SMD-Verfahren (Surface-mounted-device) auf Leiterplatten gelötet werden. Weiterhin eignen sie sich um Umspritzen von Schaltern und Relais.

Beispiele

A.Vergleichs-Beispiele:

Herstellung eines Polyarylensulfids nach einem der Beispiele 2 bis 8 in DE-OS 3 637 813 (Spalte 5 und 6), wobei Isolierung in üblicher Weise bedeutet, daß der heiße Reaktions-Ansatz in einem aliphatischen Alkohol gefällt und das Roh-PPS mit Alkohol und Wasser zur Entfernung löslicher Bestandteile gewaschen sind.

B. Erfindungsgemäße Beispiele:

1. Herstellung eines Polyarylensulfids nach einem der Beispiele 1 bis 8 in DE-OS 3 637 813 (Spalte 5 und 6), wobei der heiße Reaktions-Ansatz einer kontinuierlichen Temperung nach gängigen Methoden unterworfen wird. Der abgekühlte Reaktions-Ansatz wird in einem aliphatischen Alkohol (z.B. $C_1$-$C_6$-Alkohol) als Verdünnungsmittel eingebracht, filtriert, wie üblich angesäuert und mit einer Flüssigkeit, z.B. Wasser, gewaschen.

2. Herstellung eines Polyarylensulfides nach Beispiel B1., wobei insgesamt 1186,3 g p-Dichlorbenzol und zusätzlich 36,7 g m-Dichlorbenzol eingesetzt werden; letzteres wird mit p-Dichlorbenzol vorgelegt.

3. Herstellung eines Polyarylensulfids nach Beispiel B1., wobei insgesamt 1223 g p-Dichlorbenzol und zusätzlich 62,5 g von 2-(2,5-dichlorhpenyl)-2,4-dihyron-5-methylpyrazolon-3 eingesetzt werden; letztres wird nach der Entwässerungsphase zudosiert.

Tabelle

| Absenkung des Ionen-Gehaltes im Polyarylensulfid durch die erfindungsgemäße Aufarbeitung: | | |
|---|---|---|
| Ionen (ppm) | Beispiele A (Vergleich) | Beispiele B (erfindungsgemäß) |
| $Na^+$ | > 200 | < 20 |
| $K^+$ | > 5 | < 1 |
| $Fe^{3+}$ | > 40 | < 20 |
| $Cl^-$ | > 80 | < 5 |

4

Die so erhaltenen Copolyarylensulfide wurden in Schmelze mit 60 Gew.-% Quarzmehl bezogen auf Compound auf einer ZSK 32 (Werner + Pfleiderer) extrudiert und granuliert.

Mit der so erhaltenen Formmasse (40 Pa.s bei y = $10^3$ (1/s) (340° C) werden auf einem Versuchswerkzeug Mikrochips, deren Halbleiterkristalle durch 25 μm dünne Golddrähte mit den externen Kontakten leitfähig verbunden waren, bei 360° C Massetemperatur umspritzt.

Röntgen-Aufnahmen der umspritzten Mikrochips zeigten, daß die Bonddrähte so wenig deformiert (verdreht) waren, daß keine optischen Überschneidungen vorhanden waren.

Zu <u>B</u>

Die aus B hergestellte Formmasse (60 Pa.s bar γ = $10^3$ (1/s bewirken bei gleichen Verarbeitungsbedingungen ein deutliches Verwehen und zum Teil Abreißen der Bonddrähtchen.

Beispiel 3

Mit Formmase A werden Transistoren umspritzt und anschließend 1000 h in $H_2O$-Dampfbad bei 121° C gelagert. Im Anschluß daran wurde der Sperrstrom gemessen (11 nA).

Beispiel 4

Mit Formmasse B wurden analog Transistoren umspritzt, gelagert und geprüft. Der Sperrstrom betrug 160 nA.

**Ansprüche**

1. Thermoplastische Formmassen bestehend aus

A) 20-100 Gew.% Polyarylensulfiden, vorzugsweise Polyphenylsulfiden, mit einer Schmelzviskosität von 5 bis 20 Pa's und einem Schmelzpunkt > 260° C und einem Kristallisations-Verhalten der math. Beziehung (I)

$$t g_K (170) \rangle t_K (T_0) \cdot \frac{U(170)}{U (T_.)} \quad (I),$$

und einem Gesamtionengehalt von weniger als 200 ppm und

B) 0 bis 80 Gew.% Füllstoffen.

2. Formmassen nach Anspruch 1, dadurch gekennzeichnet, daß deren Kationen- und Anionen-Gehalt kleiner 100 ppm bezogen auf Polyarylensulfid, ist.

3. Formmasen nach Anspruch 1, dadurch gekennzeichnet, daß deren Kationen- und Anionen-Gehalt kleiner 50 ppm, bezogen auf Polyarylensulfid, ist.

4. Formmassen nach Anspruch 1, dadurch gekennzeichnet, daß deren Schmelzviskosität bei 340° C und γ = $10^3$ (1/s) kleiner 80 Pa.s ist.

5. Formmassen nach Anspruch 1, dadurch gekennzeichnet, daß deren Schmelzviskosität bei 340° C und γ = $10^3$ (1/s) kleiner 50 Pa.s ist.

6. Formmassen nach Anspruch 1 mit einem Gehalt von A) 30 bis 90 Gew.% Polyarylensulfid und B) 70 bis 10 Gew.% Füllstoffen.

7. Verfahren zur Herstellung von thermoplastischen Formmassen nach Anspruch 1, dadurch gekennzeichnet, daß die eingesetzten Polyarylensulfide (A) bzw. Copolyphenylensulfide (A) nach üblichen Verfahren hergestellt und am Ende der Synthese-Reaktion einer kontinuierlichen Temperung unterworfen werden.

8. Verwendung der Formmassen nach Anspruch 1 als Einbettmasse für aktive und passive elektronische Bauelemente.

9. Verwendung der Formmassen nach Anspruch 7 als Einbettmasse für Mikrochips.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | EP-A-0 265 524 (TOHPREN CO. LTD.)<br>* Seite 5, Zeilen 30-37; Seite 4, Zeile 32 - Seite 5, Zeile 6; Tabellen 1,2; Seite 10, Zeilen 1-20; Seite 17, Zeilen 1-8 *<br>--- | 1-5,7-9 | C 08 G 75/02<br>H 01 B 3/30 |
| P,X | EP-A-0 299 276 (BAYER AG)<br>* Patentanspruch; Beispiel; Spalte 1, Zeile 42 - Spalte 2, Zeile 50 *<br>--- | 1-5,7-9 | |
| P,A | US-A-4 730 034 (A. M. NESHEIWAT et al.)<br>* Spalte 6, Zeilen 12-59 *<br>--- | 1-5,7-9 | |
| P,A | EP-A-0 306 025 (IDEMITSU PETROCHEMICAL CO. LTD.)<br>* Beispiele 1-3 *<br>--- | 1-5,7 | |
| X | EP-A-0 214 471 (BAYER AG)<br>* Beispiel 1; Seite 15, Zeilen 15-27 *;<br>& DE - A - 3529498 (Kat. D)<br>--- | 1-9 | |
| D,A | EP-A-0 100 913 (PHILLIPS PETROLEUM COMPANY)<br>* Ansprüche *<br>----- | 6,8,9 | RECHERCHIERTE SACHGEBIETE (Int. Cl.5)<br><br>C 08 G<br>H 01 B |

Der vorliegende Recherchenbericht wurde für alle Patentansprüche erstellt

| Recherchenort | Abschlußdatum der Recherche | Prüfer |
|---|---|---|
| BERLIN | 13-11-1989 | BOEKER R.B. |